# EUROPEAN PATENT APPLICATION

(11) **EP 2 835 200 A1**
(43) Date of publication of application: **11.02.2015**
(21) Application number: 12873507.3
(22) Date of filing: 02.04.2012
(51) Int. Cl.: B23B 51/00, B23B 27/14, B23C 5/16, B23G 5/06

(54) **HARD COATING FILM FOR CUTTING TOOL AND CUTTING TOOL COATED WITH HARD COATING FILM**

(71) Applicant: OSG Corporation, Toyokawa-shi Aichi 442-0005 (JP)
(72) Inventor: SAKURAI Masatoshi, Toyokawa-shi Aichi 442-0005 (JP); TOIHARA Takaomi, Toyokawa-shi Aichi 442-0005 (JP)
(74) Representative: TBK
(86) International application number: PCT/JP2012/059012
(87) International publication number: WO 2013/150603

(57) **Abstract**

Provided are a hard coating film for a cutting tool, said hard coating film having both an excellent wear resistance and an excellent deposition resistance, and a cutting tool that is coated with the hard coating film.

A hard coating film (22) having an excellent lubricity, an excellent deposition resistance and a high hardness, said hard coating film comprising a hard phase (24) that is a nitride phase, an oxide phase, a carbide phase, a carbonitride phase or a boride phase containing at least one element selected from among a IVa group element, a Va group element, a VIa group element, Al and Si and a binding phase (26) that is a phase containing at least one element selected from among Au, Ag and Cu, wherein the hard layer (24) and the binding layer (26) are three-dimensionally arranged to form a composite structure in which the hard layer (24) is bound via the binding layer (26) comprising Au, Ag or Cu so that the coefficient of friction and cutting resistance can be reduced.

## Description

### TECHNICAL FIELD

The present invention relates to a cutting tool hard film disposed as coating on a surface of a cutting tool and a hard film coated cutting tool provided with the hard film and particularly to an improvement for increasing both abrasion resistance and welding resistance.

### BACKGROUND ART

Cutting tools such as drills and taps are provided and coated with a hard film to increase abrasion resistance. TiN-based, TiCN-based, TiAlN-based and AlCrN-based coatings are widely used for this cutting tool hard film and improvements are achieved for further increasing performance thereof. For example, this corresponds to an abrasion resistance member described in Patent Document 1.

### PRIOR ART DOCUMENT

### Patent Document

Patent Document 1: Japanese Laid-Open Patent Publication No. 2005-138209

### SUMMARY OF THE INVENTION

### Problem to Be Solved by the Invention

However, a cutting tool with a hard film formed by the conventional technique as described above may have insufficient welding resistance at the time of cutting depending on a type of work material and a cutting condition. Therefore, a tool life may be shortened due to welding of work material etc., and room for improvement exists. Therefore, it is requested to develop a cutting tool hard film and a hard film coated cutting tool excellent in both abrasion resistance and welding resistance.

The present invention was conceived in view of the situations and it is therefore an object of the present invention to provide a cutting tool hard film and a hard film coated cutting tool excellent in both abrasion resistance and welding resistance. Means for Solving the Problem

To achieve the object, the first aspect of the invention provides a cutting tool hard film disposed as coating on a surface of a cutting tool, comprising: a hard phase that is a nitride phase, an oxide phase, a carbide phase, a carbonitride phase, or a boride phase containing at least one element out of group IVa elements, group Va elements, group VIa elements, Al, and Si; and a binding phase that is a phase containing at least one element out of Au, Ag, and Cu, wherein the cutting tool hard film has composite structure with the hard phase and the binding phase three-dimensionally arranged.

### Effects of the Invention

As described above, according to the first aspect of the invention, the cutting tool hard film comprises: a hard phase that is a nitride phase, an oxide phase, a carbide phase, a carbonitride phase, or a boride phase containing at least one element out of group IVa elements, group Va elements, group VIa elements, Al, and Si; and a binding phase that is a phase containing at least one element out of Au, Ag, and Cu, the cutting tool hard film has composite structure with the hard phase and the binding phase three-dimensionally arranged, and, therefore, since the structure is achieved with the hard phase bound by Au, Ag, and Cu, friction coefficient and cutting resistance can be reduced, and a high hardness film excellent in lubricity and welding resistance is acquired. Thus, the cutting tool hard film excellent in both abrasion resistance and welding resistance can be provided.

The second aspect of the invention provides the cutting tool hard film recited in the first aspect of the invention, wherein an average particle diameter of particles making up the hard phase is within a range of 1 nm to 100 nm. Consequently, since so-called nanocomposite structure is achieved with the hard phase bound by Au, Ag, and Cu at the nano-level, friction coefficient and cutting resistance can further be reduced, and the high hardness film excellent in lubricity and welding resistance is acquired.

The third aspect of the invention which depends from the first aspect of the invention or the second aspect of the invention provides a hard film coated cutting tool having the cutting tool hard film recited in the first aspect of the invention or the second aspect of the invention disposed as coating on a surface. Consequently, since the structure is achieved with the hard phase bound by Au, Ag, and Cu, friction coefficient and cutting resistance can be reduced, and a high hardness film excellent in lubricity and welding resistance is acquired. Thus, the hard film coated cutting tool excellent in both abrasion resistance and welding resistance can be provided.

### BRIEF DESCRIPTION OF THE DRAWINGS

Fig. 1 is a diagram of a drill that is an embodiment of a hard film coated cutting tool of the present invention and is a front view from a direction orthogonal to an axial center.
Fig. 2 is an enlarged bottom view of the drill depicted in Fig. 1 viewed from a tip disposed with a cutting edge.
Fig. 3 is an enlarged cross-sectional view around a surface of a body of the drill of Fig. 1, exemplarily illustrating a configuration of a hard film that is an embodiment of a cutting tool hard film of the present invention.
Fig. 4 is a schematic of structure of the hard film of Fig. 3.
Fig. 5 is a diagram for explaining an example of a coating method of the hard film of Fig. 3.
Fig. 6 is a diagram of coating structures of samples used in a drilling test conducted by the present inventors for verifying an effect of the present invention, and also indicates respective test results.

### MODE FOR CARRYING OUT THE INVENTION

A cutting tool hard film of the present invention is preferably applied to surface coating of various cutting tools including rotary cutting tools such as end mills, drills, face mills, forming mills, reamers, and taps, as well as non-rotary cutting tools such as tool bits. Although cemented carbide and high speed tool steel are preferably used as tool base material, i.e., material of a member provided with the hard film, other materials are also available and, for example, the cutting tool hard film of the present invention is widely applied to cutting tools made of various materials such as cermet, ceramics, polycrystalline diamond, single-crystal diamond, polycrystalline CBN, and single-crystal CBN.

The cutting tool hard film of the present invention is disposed as coating on a portion or the whole of the surface of a cutting tool and is preferably disposed on a cutting portion involved with cutting in the cutting tool. More preferably, the cutting tool hard film is disposed to coat at least a cutting edge or a rake surface in the cutting portion.

The hard phase is made of nitride, oxide, carbide, carbonitride, or boride containing at least one element out of group IVa elements, group Va elements, group VIa elements, Al, and Si, or mutual solid solution thereof. Specifically, the hard phase is a phase comprising TiN, TiAlN, TiAlCrVSiB, ZrVO, HfCrCN, NbN, CrN, MoSiC, AlN, SiN, etc.

Although the cutting tool hard film of the present invention is preferably disposed by, for example, a PVD method such as an arc ion plating method, an ion beam deposition method, a sputtering method, a PLD (Pulse Laser Deposition) method, and an IBAD (Ion Beam Assisted Deposition) method, other film formation methods such as a plating method, a liquid quenching method, and a gas aggregation method are also employable.

### Embodiment

A preferred embodiment of the present invention will now be described in detail with reference to the drawings. In the drawings used in the following description, portions are not necessarily precisely depicted in terms of dimension ratio, etc.

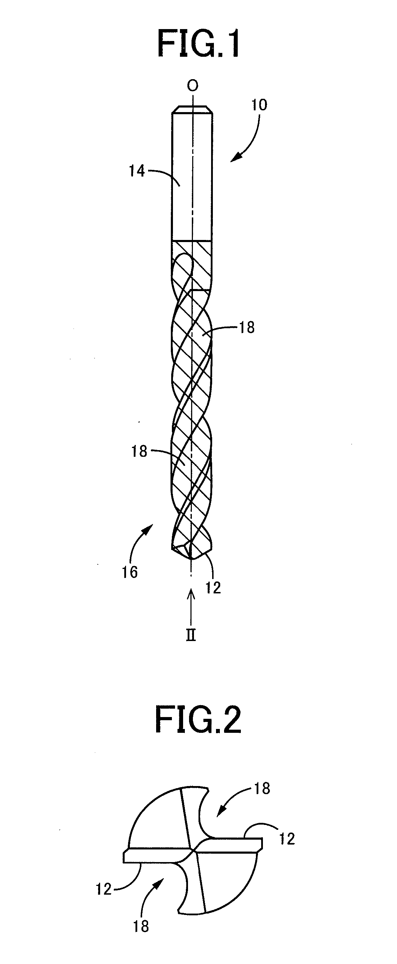

Fig. 1 is a diagram of a drill 10 that is an embodiment of a hard film coated cutting tool of the present invention and is a front view from a direction orthogonal to an axial center O. Fig. 2 is an enlarged bottom view of the drill 10 depicted in Fig. 1 viewed from a tip disposed with a cutting edge 12 (i.e., a direction indicated by an arrow II). The drill 10 of this embodiment depicted in Figs. 1 and 2 is a two-flute twist drill and integrally includes a shank 14 and a body 16 in the axial center O direction. The body 16 has a pair of flutes 18 twisted clockwise around the axial center O. The tip of the body 16 is provided with a pair of the cutting edges 12 corresponding to the pair of the flutes 18 and, when the drill 10 is rotationally driven clockwise around the axial center O in a view from the shank 14, a hole is cut in work material by the cutting edges 12 while chips generated at the time of cutting of the hole are discharged through the flutes 18 toward the shank 14.

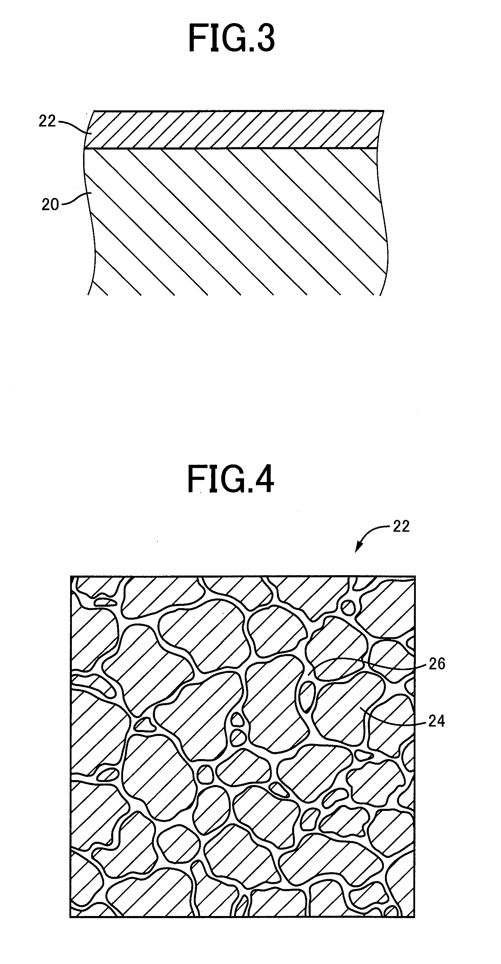

Fig. 3 is an enlarged cross-sectional view around a surface of the body 16 of the drill 10, exemplarily illustrating a configuration of a hard film 22 that is an embodiment of the cutting tool hard film of the present invention. Fig. 4 is a schematic of structure of the hard film 22 photographed by a TEM (transmission electron microscope). As depicted in Fig. 3, the drill 10 is formed by coating a surface of a tool base material (tool parent material) 20 made of high speed tool steel (high-speed steel) with the hard film 22, for example. Film thickness of the hard film 22 is preferably about 2.5 to 6.0 µm. As depicted in Fig. 4, the hard film 22 has structure in which multiple particles (particulate elements) making up a hard phase 24 are bound to each other by a binding phase 26 disposed in gaps thereof. Although a planar microscope photograph is exemplarily illustrated in Fig. 4, the hard film 22 has the structure in which the hard phase 24 and the binding phase 26 are bound to each other as depicted in Fig. 4 in both the planar direction (direction parallel to the surface) and the thickness direction (direction perpendicular to the surface). Therefore, the hard film 22 has composite structure with the hard phase 24 and the binding phase 26 three-dimensionally (sterically) arranged.

The binding phase 26 is a phase comprising Au, Ag, or Cu containing unavoidable impurities, or mutual solid solution thereof. The hard phase 24 is made of nitride, oxide, carbide, carbonitride, or boride containing at least one element out of group IVa elements, group Va elements, group VIa elements, Al, and Si, or mutual solid solution thereof, and contains unavoidable impurities. Therefore, specifically, the hard phase 24 is a phase (dispersed phase) comprising TiN, TiAlN, TiAlCrVSiB, ZrVO, HfCrCN, NbN, CrN, MoSiC, AlN, SiN, etc. Preferably, an average particle diameter of the particles making up the hard phase 24 is within a range of 1 nm to 100 nm. For example, the average particle diameter of the particles making up the hard phase 24 is calculated for a plurality of particles (particulate elements) making up the hard phase 24 randomly extracted from a microscope photograph as depicted in Fig. 4, based on an average value of long diameters, short diameters, or long and short diameters corresponding to diameter dimensions of the particles. For example, an average value of the diameter dimensions in the plurality of the extracted particles is calculated as the average particle diameter. In other words, the hard film 22 has nanocomposite structure in which the hard phase 24 formed into particles having a size within a range of 1 nm to 100 nm is dispersively (diffusively) disposed in the binding phase 26 acting as a matrix. Therefore, the hard film 22 comprises nanostructured metal made up of multiple-phase nanocrystals.

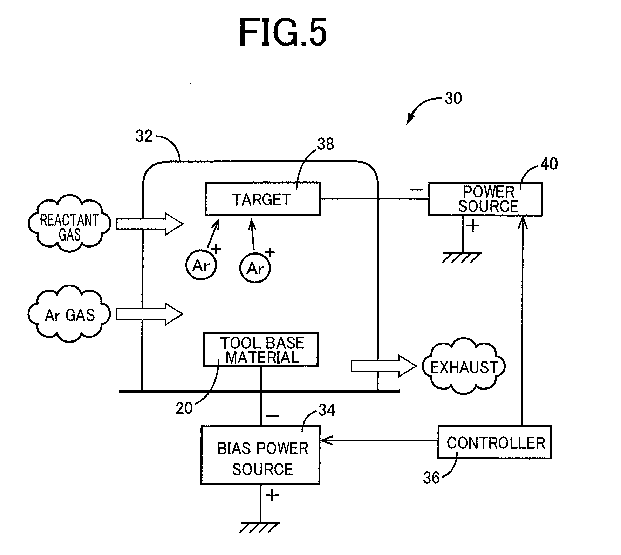

Fig. 5 is a diagram for explaining an example of a coating method of the hard film 22. Coating of the hard film 22 on the drill 10 etc. is performed by using, for example, a sputtering apparatus 30 as depicted in Fig. 5 under control of a controller 36. Preferably, first, in an etching process used as pretreatment, a negative bias voltage is applied by a bias power source 34 to the tool base material 20 placed in a chamber 32 of the sputtering apparatus 30. This causes positive argon ions Ar⁺ to collide with the tool base material 20 and the surface of the tool base material 20 is roughened.

Subsequently, for example, the hard phase 24 in the hard film 22 is formed in a sputtering process. For example, a constant negative bias voltage (e.g., about -50 to -60 V) is applied by a power source 40 to a target 38 such as Si making up the hard phase 24 while a constant negative bias voltage (e.g., about -100 V) is applied by the bias power source 34 to the tool base material 20 so as to cause the argon ions Ar⁺ to collide with the target 38, thereby beating out constituent material such as Si. Reactant gas such as nitrogen gas (N₂) and hydrocarbon gas (CH₄, C₂H₂) is introduced into the chamber 32 at predetermined flow rates in addition to argon gas, and nitrogen atoms N and carbon atoms C combine with Si etc. beaten out from the target 38 to form SiN etc., which are attached as the hard phase 24 in the hard film 22 to the surface of the tool base material 20. This treatment is executed alternately with treatment of the sputtering process using Ag etc. making up the binding phase 26 as the target 38 to form the hard film 22 having the composition as depicted in Fig. 4 on the surface of the tool base material 20. Alternatively, targets may be respectively formed for the hard phase 24 and the binding layer 26, and the sputtering may be performed by using the multiple targets in a synchronized manner to form the hard film 22 on the surface of the tool base material 20.

Other preferably used methods of forming the hard film 22 on the surface of the tool base material 20 include, for example, a well-known plating method (plating technique), a liquid quenching method in which molten alloy acquired by melting the metal making up the hard film 22 is quenched faster than a rate causing crystal nucleation to acquire amorphous alloy, and a gas aggregation method in which nanoparticles acquired by evaporating and aggregating the metal making up the hard film 22 in He gas are deposited on a substrate cooled by liquid nitrogen to solidify and form nano-fine powder scraped off from the substrate.

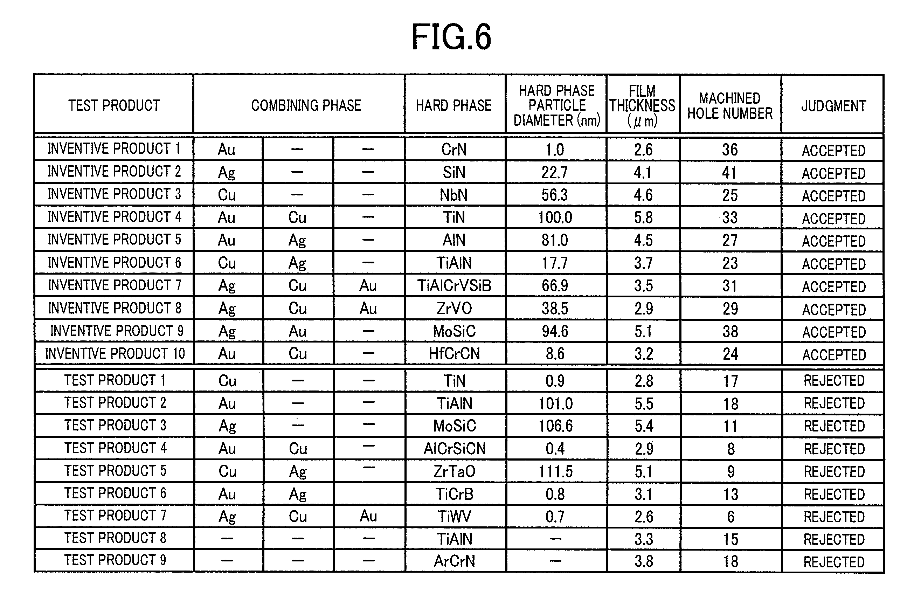

A drilling test conducted by the present inventors for verifying an effect of the present invention will then be described. Fig. 6 is a diagram of coating structures of inventive products and test products used in this test and respective test results (machined hole numbers and judgments). The present inventors created inventive products 1 to 10 and test products 1 to 9 as samples by coating cemented carbide drills having a tool diameter of 8.3 mmϕ with hard films having respective film structures and film thicknesses depicted in Fig. 6 and conducted a cutting test for each of the test products under the following cutting conditions. Out of the samples depicted in Fig. 6, the inventive products 1 to 10 correspond to inventive products to which the hard film 22 of this embodiment is applied and the test products 1 to 9 correspond to non-inventive products to which a hard film not satisfying the requirement of the present invention (out of the requirement of claim 1 or 2) is applied. A hard-phase particle diameter in Fig. 6 is an average value of diameter dimensions of multiple hard-phase constituent particles randomly extracted from a microscope photograph etc. of a film of each sample. The machined hole number depicted in Fig. 6 is the hole number when a flank wear width is 0.2 mm and an acceptance criterion is the machined hole number equal to or greater than 20 when the flank wear width is 0.2 mm.

[Machining Conditions]
Tool shape: ϕ8.3 cemented carbide drill
Work material: Inconel (registered trademark) 718
Cutting machine: vertical type M/C
Cutting speed: 10 m/min
Feed speed: 0.1 mm/rev
Machining depth: 33mm (blind)
Step amount: non-step
Cutting oil: oil-based

As depicted in Fig. 6, all the inventive products 1 to 10 include the hard phase 24 that is a nitride phase, an oxide phase, a carbide phase, a carbonitride phase, or a boride phase containing at least one element out of group IVa elements, group Va elements, group VIa elements, Al, and Si, and the binding phase 26 that is a phase containing at least one element out of Au, Ag, and Cu, and have composite structure with the hard phase 24 and the binding phase 26 three-dimensionally arranged. An average particle diameter of the particles making up the hard phase 24 is within a range of 1 nm to 100 nm. Therefore, the hard film 22 satisfying the requirements of claims 1 and 2 of the present invention is applied to all the inventive products 1 to 10. As apparent from the test results depicted in Fig. 6, the acceptance criterion is satisfied by the inventive products 1 to 10 to which the hard film 22 of the embodiment is applied since all the samples have the machined hole numbers equal to or greater than 20 when the flank wear width is 0.2 mm.

Particularly, the inventive product 2 includes the hard phase 24 comprising SiN and the binding phase 26 comprising Ag with the average particle diameter of 22.7 nm for the hard phase 24 and the film thickness of 4.1 µm, and results in the machined hole number of 41; the inventive product 9 includes the hard phase 24 comprising MoSiC and the binding phase 26 comprising Ag and Au with the average particle diameter of 94.6 nm for the hard phase 24 and the film thickness of 5.1 µm, and results in the machined hole number of 38; the inventive product 1 includes the hard phase 24 comprising CrN and the binding phase 26 comprising Au with the average particle diameter of 1.0 nm for the hard phase 24 and the film thickness of 2.6 µm, and results in the machined hole number of 36; the inventive product 4 includes the hard phase 24 comprising TiN and the binding phase 26 comprising Au and Cu with the average particle diameter of 100.0 nm for the hard phase 24 and the film thickness of 5.8 µm, and results in the machined hole number of 33; the inventive product 7 includes the hard phase 24 comprising TiAlCrVSiB and the binding phase 26 comprising Ag, Cu, and Au with the average particle diameter of 66.9 nm for the hard phase 24 and the film thickness of 3.5 µm, and results in the machined hole number of 31; and, therefore, it can be seen that these inventive products result in the machined hole numbers equal to or greater than 30 when the flank wear width is 0.2 mm and exhibit particularly favorable cutting performance.

Although including the hard phase 24 that is a nitride phase, an oxide phase, a carbide phase, a carbonitride phase, or a boride phase containing at least one element out of group IVa elements, group Va elements, group VIa elements, Al, and Si, and the binding phase 26 that is a phase containing at least one element out of Au, Ag, and Cu, all the test products 1 to 7 have an average particle diameter of the particles making up the hard phase 24 deviating from the range of 1 nm to 100 nm and do not satisfy the requirement of claim 2 of the present invention. In particular, the test products 1, 4, 6, and 7 have a smaller average particle diameter of the particles making up the hard phase 24 less than 1 nm and the test products 2, 3, and 5 have an average particle diameter of the particles making up the hard phase 24 larger than 100 nm. If a hard film has an average particle diameter of the particles making up the hard phase 24 deviating from the range of 1 nm to 100 nm as described above, the hard film cannot have preferred nanocomposite structure with the hard phase 24 dispersively (diffusively) disposed in the binding phase 26 or, in other words, does not have composite structure with the hard phase 24 and the binding phase 26 three-dimensionally arranged. Therefore, none of the test products 1 to 7 satisfies the requirement of claim 1 of the present invention. None of the test products 8 and 9 has the binding phase 26 that is a phase containing at least one element out of Au, Ag, and Cu, and satisfies the requirement of claim 1 of the present invention. As apparent from the test results depicted in Fig. 6, it can be seen that all the test products 1 to 9 have the machined hole numbers less than 20 when the flank wear width is 0.2 mm and are inferior in cutting performance to the inventive products 1 to 10. It is considered that this is because a hard film not satisfying the requirement of claim 1 or 2 of the present invention has insufficient welding resistance and reaches the end of life earlier due to welding, peeling, etc.

As described above, this embodiment includes the hard phase 24 that is a nitride phase, an oxide phase, a carbide phase, a carbonitride phase, or a boride phase containing at least one element out of group IVa elements, group Va elements, group VIa elements, Al, and Si, and the binding phase 26 that is a phase containing at least one element out of Au, Ag, and Cu, and has composite structure with the hard phase 24 and the binding phase 26 three-dimensionally arranged and, therefore, since the structure is achieved with the hard phase 24 bound by Au, Ag, and Cu, friction coefficient and cutting resistance can be reduced, and a high hardness film excellent in lubricity and welding resistance is acquired. Thus, the cutting tool hard film 22 excellent in both abrasion resistance and welding resistance can be provided.

An average particle diameter of the particles making up the hard phase 24 is within the range of 1 nm to 100 nm and, therefore, since so-called nanocomposite structure is achieved with the hard phase 24 bound by Au, Ag, and Cu at the nano-level, friction coefficient and cutting resistance can further be reduced, and the high hardness hard film 22 excellent in lubricity and welding resistance is acquired.

This embodiment provides the drill 10 as a hard film coated cutting tool having the hard film 22 disposed as coating on a surface and, therefore, since the structure is achieved with the hard phase 24 bound by Au, Ag, and Cu, friction coefficient and cutting resistance can be reduced, and a high hardness film excellent in lubricity and welding resistance is acquired. Thus, the drill 10 excellent in both abrasion resistance and welding resistance can be provided.

Although the preferred embodiment of the present invention has been described in detail with reference to the drawings, the present invention is not limited thereto and is implemented with various modifications applied within a range not departing from the spirit thereof.

### NOMENCLATURE OF ELEMENTS

10: drill (hard film coated cutting tool) 12: cutting edge 14: shank 16: body 18: flutes 20: tool base material 22: hard film (cutting tool hard film) 24: hard phase 26: binding phase 30: sputtering apparatus 32: chamber 34: bias power source 36: controller 38: target 40: power source

## Claims

1. A cutting tool hard film disposed as coating on a surface of a cutting tool, comprising:
a hard phase that is a nitride phase, an oxide phase, a carbide phase, a carbonitride phase, or a boride phase containing at least one element out of group IVa elements, group Va elements, group VIa elements, Al, and Si; and
a binding phase that is a phase containing at least one element out of Au, Ag, and Cu, wherein
the cutting tool hard film has composite structure with the hard phase and the binding phase three-dimensionally arranged.

2. The cutting tool hard film of claim 1, wherein an average particle diameter of particles making up the hard phase is within a range of 1 nm to 100 nm.

3. A hard film coated cutting tool having the cutting tool hard film of claim 1 or 2 disposed as coating on a surface.
